(19) **Europäisches Patentamt / European Patent Office / Office européen des brevets**

(11) **EP 3 827 270 B1**

(12) **EUROPÄISCHE PATENTSCHRIFT**

(45) Veröffentlichungstag und Bekanntmachung des Hinweises auf die Patenterteilung:
**03.08.2022   Patentblatt 2022/31**

(21) Anmeldenummer: **19742530.9**

(22) Anmeldetag: **02.07.2019**

(51) Internationale Patentklassifikation (IPC):
**G01R 27/20** *(2006.01)*      **G01R 15/18** *(2006.01)*

(52) Gemeinsame Patentklassifikation (CPC):
**G01R 15/183; G01R 31/69;** G01R 27/205

(86) Internationale Anmeldenummer:
**PCT/EP2019/067760**

(87) Internationale Veröffentlichungsnummer:
**WO 2020/020586 (30.01.2020 Gazette 2020/05)**

(54) **ÜBERWACHUNG DES KONTAKTBEREICHES IN EINER STECKVORRICHTUNG**

MONITORING OF THE CONTACT REGION IN A PLUG DEVICE

SURVEILLANCE DE LA ZONE DE CONTACT DANS UN DISPOSITIF À ENFICHAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.07.2018   DE 102018117815**

(43) Veröffentlichungstag der Anmeldung:
**02.06.2021   Patentblatt 2021/22**

(73) Patentinhaber: **AMAD MENNEKES HOLDING GMBH & CO. KG**
**57399 Kirchhundem (DE)**

(72) Erfinder:
• **LUBELEY, Markus**
**57399 Kirchhundem (DE)**

• **DIDAM, Stephan**
**57392 Schmallenberg (DE)**
• **KLOS, Stefan**
**57392 Schmallenberg (DE)**

(74) Vertreter: **Beckmann, Jürgen**
**Dr. Jürgen Beckmann**
**Patentanwalt**
**An der Baumschule 23**
**57462 Olpe (DE)**

(56) Entgegenhaltungen:
| | |
|---|---|
| **EP-A2- 0 726 620** | **EP-A2- 2 944 503** |
| **BE-A- 427 716** | **CN-U- 202 008 524** |
| **CN-U- 206 848 406** | **DE-A1- 4 033 052** |
| **JP-A- 2007 285 833** | **US-B1- 6 529 011** |

**Beschreibung**

Die Erfindung betrifft ein Verfahren zur Bestimmung der elektrischen Übergangseigenschaften wie insbesondere des Übergangswiderstandes im Kontaktbereich zwischen zwei Kontaktelementen (Steckerstift, Buchse) einer Steckvorrichtung. Des Weiteren betrifft sie eine zur Durchführung dieses Verfahrens eingerichtete Steckvorrichtung.

Elektrische Steckvorrichtungen wie zum Beispiel Stecker oder Steckdosen bzw. Kupplungen für Kraftstrom nach DIN VDE 0623, EN 60309-2 ("CEE-Steckvorrichtungen") oder nach IEC 62196 ("E-Auto-Ladesteckvorrichtungen") enthalten metallische Kontaktelemente (Stifte bei einem Stecker und Buchsen bei einer Dose), über welche im zusammengesteckten Zustand der elektrische Kontakt stattfindet. Durch Verschmutzung, Oxidation, Nachlassen der Kontaktkräfte und dergleichen können im Kontaktbereich zwischen diesen Kontaktelementen nicht zu vernachlässigende elektrische Widerstände auftreten. Gerade bei Kraftsteckvorrichtungen, bei denen im Betrieb verhältnismäßig hohe Ströme fließen, können solche Übergangswiderstände zu intolerablen Leistungsverlusten führen. Da verlorengegangene Leistung in Wärme umgesetzt wird, besteht darüber hinaus das Risiko einer gefährlichen Überhitzung. Im Stand der Technik sind daher verschiedene Maßnahmen vorgeschlagen worden, um die Temperatur in einer Steckvorrichtung zu überwachen. Allerdings können derartige Systeme erst reagieren, wenn bereits eine Erwärmung und damit eine potentiell problematische Situation eingetreten ist.

Aus der JP 2007 285833 ist eine Detektionsschaltung zur Detektion anormaler Verhältnisse an einem Steckkontakt bekannt. Um den Spannungsfall über den Steckkontakt messen zu können, ist ein zusätzlicher Steckkontakt vorgesehen. Ähnliche Anordnungen zeigen auch die CN 206848406 und die CN 202008524.

Weiterhin ist aus der EP 2 944 503 A2 eine elektrische Leistungsschnittstelle eines Fahrzeugs bekannt, welche einen Leistungspfad mit einem ersten und einem zweiten Leistungskontakt enthält. Ferner umfasst sie einen Hilfskontakt, der elektrisch isoliert zu dem ersten Leistungskontakt angeordnet ist und den zweiten Leistungskontakt ebenfalls kontaktiert, wobei über den Hilfskontakt ein Messpfad geschaltet ist zur Erfassung des Zustands einer elektrischen Kontaktierung zwischen dem ersten Leistungskontakt und dem zweiten Leistungskontakt.

Vor diesem Hintergrund war es Aufgabe der vorliegenden Erfindung, alternative Mittel zur Bestimmung bzw. Überwachung der Funktion einer Steckvorrichtung bereitzustellen. Vorzugsweise sollen diese dabei eine möglichst frühe Erkennung problematischer Situationen ermöglichen.

Diese Aufgabe wird durch Verfahren sowie durch Steckvorrichtungen mit den Merkmalen der unabhängigen Ansprüche gelöst. Vorteilhafte Ausgestaltungen sind in den Unteransprüchen enthalten.

Ein Verfahren gemäß der vorliegenden Erfindung dient der Bestimmung der elektrischen Übergangseigenschaften im Kontaktbereich zwischen einem Kontaktelement einer ersten Steckvorrichtung (im Folgenden auch "erstes Kontaktelement" genannt) und einem dazu komplementären Kontaktelement (auch "zweites Kontaktelement" genannt) einer komplementären zweiten Steckvorrichtung. Die erste Steckvorrichtung kann eine Kupplung mit Buchsen als ersten Kontaktelementen und die zweite Steckvorrichtung ein Stecker mit Steckerstiften als zweiten Kontaktelementen sein, oder umgekehrt, wobei die Steckvorrichtungen außer den Kontaktelementen in der Regel noch weitere Komponenten (Gehäuse, Einsätze etc.) enthalten. Das Verfahren ist dadurch gekennzeichnet, dass die Eigenschaften mindestens eines Strompfades ausgewertet werden, welcher

- das erste Kontaktelement,

- den Kontaktbereich, und

- von der zweiten Steckvorrichtung nur das zweite, komplementäre Kontaktelement und gegebenenfalls weitere Kontaktelemente der zweiten Steckvorrichtung

enthält.

Der Strompfad bildet definitionsgemäß eine elektrisch leitende Verbindung zwischen zwei Anschlüssen, über welche ein Gleichstrom oder zumindest ein Wechselstrom fließen kann oder fließt. Sind diese Anschlüsse identisch, so liegt ein Stromkreis vor. Andernfalls wird ein geschlossener Stromkreis typischerweise durch die Verbindung der Anschlüsse mit einer Auswerteschaltung hergestellt.

Die Enden bzw. Anschlüsse des Strompfades liegen typischerweise in bzw. sind Bestandteile von der ersten Steckvorrichtung, so dass der Strompfad vollständig von der ersten Steckvorrichtung aus zugänglich ist.

Die elektrische Leitfähigkeit des Strompfades kann konduktiv sein, also den Fluss eines Gleichstromes erlauben (wobei die Höhe des ohmschen Widerstandes typischerweise kleiner als ca. 100 kΩ ist). Zusätzlich oder alternativ kann eine kapazitive Leitfähigkeit des Strompfades vorliegen, beispielsweise wenn dieser eine Kapazität in Reihenschaltung enthält (wobei die Größe einer solchen Kapazität typischerweise mehr als ca. 10 pF beträgt, vorzugsweise mehr als ca. 100 pF, mehr als 1 nF, oder mehr als 3 nF).

Die Bestimmung der elektrischen Übergangseigenschaften kann sowohl qualitativ als auch quantitativ erfolgen. Eine qualitative Bestimmung könnte beispielsweise in der Feststellung bestehen, dass die Übergangseigenschaften für einen sicheren Betrieb geeignet sind oder aber ungeeignet sind. Eine quantitative Bestimmung kann sich insbesondere auf die Bestimmung des Wertes des Übergangswiderstandes zwischen dem ersten und dem zweiten Kontaktelement beziehen.

Das Verfahren hat den Vorteil, dass durch die Ausnutzung des beschriebenen Strompfades eine Bestimmung der elektrischen Übergangseigenschaften allein von der Seite der ersten Steckvorrichtung aus möglich ist. Von der zweiten Steckvorrichtung wird zur Vervollständigung des Strompfades nämlich nur das komplementäre zweite Kontaktelement (und gegebenenfalls bzw. in Ausnahmefällen noch ein oder mehrere andere Kontaktelemente der zweiten Steckvorrichtung) verwendet, welches beim Steckvorgang jedoch ohnehin mit dem ersten Kontaktelement zusammengefügt wird. Daher sind im Ergebnis keine baulichen Veränderungen an der zweiten Steckvorrichtung notwendig, sodass das Verfahren unabhängig von Typ, Alter, Hersteller und dergleichen der zum Einsatz kommenden zweiten Steckvorrichtung ist.

Die konkrete Zusammensetzung des verwendeten Strompfades sowie das angewendete Messprinzip können verschieden ausgestaltet werden. Gemäß einer ersten Ausführungsform enthält der verwendete Strompfad mindestens einen Fühler, welcher in der ersten Steckvorrichtung angeordnet ist und welcher im zusammengesteckten Zustand der beiden Steckvorrichtungen das komplementäre zweite Kontaktelement in einem weiteren (anderen) Kontaktbereich kontaktiert. Ein derartiger Fühler ist üblicherweise nicht in einer herkömmlichen Steckvorrichtung vorhanden, sondern wird ausschließlich oder unter anderem für das vorliegende Verfahren vorgesehen. Durch den Fühler werden im zusammengesteckten Zustand zwei Kontaktbereiche zwischen der ersten Steckvorrichtung und dem komplementären zweiten Kontaktelement bereitgestellt. Daher kann ein im Wesentlichen in der ersten Steckvorrichtung realisierter Strompfad das zwischen den beiden Kontaktbereichen gelegene Stück des zweiten Kontaktelementes (und nichts Weiteres der zweiten Steckvorrichtung) enthalten. Der Übergangswiderstand im interessierenden Kontaktbereich zwischen den Kontaktelementen der Steckvorrichtungen liegt in diesem Strompfad und wird daher einer Messung zugänglich.

Bei einer ersten Weiterbildung der vorstehend beschriebenen Ausführungsform mit einem Fühler wird über den gebildeten Strompfad der Spannungsfall gemessen, der beim Fluss eines Betriebsstromes über den interessierenden Kontaktbereich auftritt. Der "Betriebsstrom" fließt dabei definitionsgemäß während des originär vorgesehenen Betriebes der Steckvorrichtung über die betrachteten (und typischerweise über mindestens zwei weitere) Kontaktelemente, um beispielsweise einen Verbraucher wie einen Elektromotor anzutreiben oder einen Akkumulator aufzuladen. Bei Kraftsteckvorrichtungen liegt dieser Betriebsstrom im Bereich von ein- bis dreistelligen Ampere-Werten, sodass auch ein verhältnismäßig kleiner Übergangswiderstand zu einem beachtlichen, nachweisbaren Spannungsfall führt. Dieser Spannungsfall tritt auch in dem gebildeten Auswertungs-Strompfad auf und bildet einen Indikator für die Übergangseigenschaften im interessierenden Kontaktbereich. Falls zusätzlich die Größe des der Messung zugrundeliegenden Betriebsstromes bekannt ist, kann außer dem ermittelten Spannungsfall auch der herrschende Übergangswiderstand im Kontaktbereich berechnet werden.

Bei der Verwendung eines Fühlers ist zu beachten, dass im Kontaktbereich zwischen diesem und dem zweiten Kontaktelement der zweiten Steckvorrichtung in der Regel ebenfalls unbekannte Übergangseigenschaften vorliegen, die gegebenenfalls die Bestimmung der Übergangseigenschaften im interessierenden Kontaktbereich erschweren. Daher können optional vor einer Auswertung bzw. einer zur Auswertung führenden Messung definierte Übergangseigenschaften zwischen dem Fühler und dem zweiten Kontaktelement der zweiten Steckvorrichtung hergestellt werden. Hierfür gibt es verschiedene Möglichkeiten. Beispielsweise könnte durch konstruktive Maßnahmen ein möglichst gut definierter, reproduzierbarer Kontaktdruck bereitgestellt werden. Desto höher der Kontaktdruck, desto höher die Wahrscheinlichkeit, dass Oxide, Fremdschichten usw. durchbrochen werden. Allerdings sind der Erhöhung des Kontaktdruckes Grenzen gesetzt: durch den Fühler sollen die Betätigungskräfte des Steckers nur geringfügig steigen. Ergänzend oder alternativ kann eine mit elektrischen Methoden arbeitende Prozedur angewendet werden, bei welcher durch Anlegen einer geeigneten Spannung (im Folgenden "Durchschlagspannung" genannt) eine eventuell vorhandene Isolierschicht (aus Oxiden, Fremdschichten oder dergleichen) durchschlagen wird. Nach diesem auch "Fritten" genannten Vorgang liegt die Spannung im Übergangsbereich zwischen den Kontaktelementen in der Regel maximal in der Größenordnung der Schmelzspannung des Materials der Kontaktoberfläche. Damit ist ein definierter Wert bzw. zumindest ein definierter Maximalwert gewährleistet.

Gemäß einer weiteren Ausführungsform enthält die erste Steckvorrichtung zwei (oder mehr) Fühler, mit jeweils eigenem und separatem Kontaktbereich zum zweiten Kontaktelement. Daher können drei oder mehr Strompfade ausgewertet werden, welche unterschiedliche Kombinationen der mindestens drei Kontaktbereiche enthalten, die zwischen (a) dem zweiten Kontaktelement und (b) dem ersten Kontaktelement und/oder den verschiedenen Fühlern gebildet werden. Somit sind mehrere unabhängige Messungen möglich, aus denen die unbekannten Größen wie beispielsweise die Übergangswiderstände bestimmt werden können.

Bei einer anderen Ausführungsform der Erfindung wird in dem verwendeten Strompfad eine Induktionsspannung erzeugt. Dies hat den Vorteil, dass ohne mechanisch/elektrische Kontaktierung Messungen im besagten Strompfad gemacht werden können, welche Rückschlüsse auf die interessierenden Übergangseigenschaften ermöglichen.

Bei einer speziellen Ausgestaltung der vorstehenden Ausführungsform bildet der betrachtete Strompfad die Sekundärspule (in der Regel mit einer einzigen Windung) an einem magnetischen Kern, welcher in der ersten Steckvorrichtung angeordnet ist und an welchem weiterhin eine Primärspule angeordnet ist. Über die Primärspule kann dann kontrolliert eine Anregung des Systems erfolgen, die über den magnetischen Kern zur Erzeugung der Induktionsspannung in der Sekundärspule führt, d.h. in dem betrachteten Strompfad. Die elektrischen Eigenschaften des Strompfades hängen dabei von den interessierenden Übergangseigenschaften im Kontaktbereich ab und lassen sich zum Beispiel als Rückwirkung in der Primärspule nachweisen. Beispielsweise lässt sich an der Primärspule die Eingangsimpedanz des Systems bestimmen, welche in definierter Weise vom Übergangswiderstand im interessierenden Kontaktbereich abhängt.

Zusätzlich oder alternativ können die elektrischen Eigenschaften des Strompfades im vorstehenden Fall auch mit Hilfe einer separaten, um den Strompfad gelegten Messspule ermittelt werden.

Die Buchsen von Steckvorrichtungen sind häufig konstruktiv so ausgestaltet, dass sie zwei oder mehr parallel um einen zylindrischen Hohlraum herum angeordnete Kontaktfinger enthalten, die parallel von einer gemeinsamen Basis der Buchse abstehen. Jeder dieser Kontaktfinger hat einen eigenen Übergangsbereich zu einem eingesteckten Steckerstift und kann daher im Rahmen des hier beschriebenen Verfahrens als ein eigenständiges "erstes Kontaktelement" angesehen werden. Für den Betrieb der Steckvorrichtung interessiert in der Regel jedoch nur der von allen Kontaktfingern gemeinsam (in Parallelschaltung) mit dem zugehörigen Steckerstift gebildete Übergangswiderstand, sodass die Kontaktfinger ein und derselben Buchse im Rahmen des hier beschriebenen Verfahrens auch als ein einziges "erstes Kontaktelement" behandelt werden können. Der Übergangswiderstand zu diesem "ersten Kontaktelement" wird dann durch die Parallelschaltung der Übergangswiderstände zu den einzelnen Kontaktfingern gebildet.

Bei Buchsen mit mehreren Kontaktfingern können diese an ihrem freien ("distalen") Ende elektrisch leitend miteinander verbunden sein, beispielsweise über einen außen umlaufenden Federring, der die Kontaktfinger nach innen drückt. Wenn dagegen zwei oder mehr Kontaktfinger einer Buchse außerhalb der gemeinsamen Basis elektrisch voneinander getrennt sind, kann der betrachtete Strompfad so gebildet werden, dass sie darin seriell angeordnet sind. Ein Teil der Kontaktfinger bildet dann einen ersten Abschnitt des Strompfades, ein anderer Teil der Kontaktfinger einen zweiten Abschnitt, wobei diese beiden Abschnitte einerseits durch einen eingesteckten Steckerstift und anderseits durch die gemeinsame Basis der Kontaktfinger elektrisch verbunden werden. Bei einer solchen Konfiguration kann ein Teil der Kontaktfinger beispielsweise auf der einen und ein anderer Teil der Kontaktfinger auf der anderen Seite eines ringförmigen magnetischen Kerns angeordnet sein, sodass insgesamt eine Windung einer Sekundärspule gemäß der obigen Beschreibung gebildet wird.

Die vorstehenden Überlegungen gelten analog auch für den Fall eines in Längsrichtung geteilten Steckerstiftes, wobei die Teile dieses Stiftes die Rolle der Kontaktfinger übernehmen.

Bei allgemeineren Bauformen der Kontaktelemente kann ein magnetischer Kern auch den Kontaktbereich zwischen dem ersten und dem zweiten Kontaktelement umschließend angeordnet sein. In diesem Fall ist beispielsweise unabhängig von einem Freistehen der Kontaktfinger die Induktion einer Spannung im betrachteten Strompfad möglich.

Je nach Ausgestaltung interagiert das beschriebene Verfahren unterschiedlich mit dem üblichen Betrieb der Steckvorrichtung. Bei der oben diskutierten Bestimmung eines Spannungsfalls im interessierenden Kontaktbereich ist der Betrieb der Steckvorrichtung beispielsweise notwendig für die Durchführung des Verfahrens. Bei einer Auswertung unter Erzeugung einer Induktionsspannung können sich dagegen die im Betrieb fließenden hohen Ströme störend auswirken. Daher kann es im Allgemeinen bevorzugt sein, wenn die Auswertung nach dem erfindungsgemäßen Verfahren mit dem Verlauf eines Betriebsstromes synchronisiert wird. Dies kann beispielsweise im Sinne einer AN/AUS Synchronisation bedeuten, dass die Auswertung nur erfolgt, wenn kein Betriebsstrom fließt, oder dass sie umgekehrt nur erfolgt, wenn Betriebsstrom fließt. Des Weiteren kann die Synchronisation jedoch auch auf eine Modulation des Betriebsstromes bezogen sein, beispielsweise wenn Messungen bevorzugt im Bereich der Nulldurchgänge eines Betriebs-Wechselstromes vorgenommen werden.

Gemäß einem zweiten Aspekt betrifft die Erfindung eine Steckvorrichtung (im Folgenden auch "erste Steckvorrichtung" genannt) mit mindestens einem ersten Kontaktelement, welches ein zweites (komplementäres) Kontaktelement einer zweiten, komplementären Steckvorrichtung im zusammengesteckten Zustand der Steckvorrichtungen in einem Kontaktbereich kontaktiert, wobei die Steckvorrichtung dazu eingerichtet ist, die Eigenschaften mindestens eines Strompfades auszuwerten, welcher das erste Kontaktelement, den Kontaktbereich, und von der zweiten Steckvorrichtung nur das zweite Kontaktelement sowie optional weitere Kontaktelemente der zweiten Steckvorrichtung enthält.

Die Vorrichtung ist somit dazu eingerichtet, ein Verfahren gemäß einer der oben beschriebenen Ausführungsformen auszuführen. Die auf das Verfahren bezogenen Erläuterungen und Modifikationen gelten daher sinngemäß auch für die Steckvorrichtung und umgekehrt.

Gemäß einer Weiterbildung enthält die Steckvorrichtung vorzugsweise mindestens einen Fühler, welcher in der ersten Steckvorrichtung angeordnet ist und im zusammengesteckten Zustand mit der zweiten Steckvorrichtung das komplementäre zweite Kontaktelement in einem weiteren Kontaktbereich kontaktiert. Der Fühler ist typischerweise vom ersten Kontaktelement elektrisch isoliert, sodass er einen separaten elektrischen Zugang zum zweiten Kontaktelement bietet.

Bei einer weiteren Ausführungsform enthält die Steckvorrichtung einen magnetischen Kern, welcher das erste Kontaktelement und/oder einen Fühler der vorstehend beschriebenen Art und/oder den Kontaktbereich umgibt. Mit einem solchen magnetischen Kern kann im ersten Kontaktelement bzw. dem Fühler und damit im betrachteten Strompfad eine Spannung induziert werden. Vorzugsweise befindet sich zu diesem Zweck an dem magnetischen Kern weiterhin eine Primärspule. Weiterhin kann der Kern optional umlaufend geschlossen sein oder eine lokale bzw. verteilte Unterbrechung ("Luftspalt") aufweisen.

Die Steckvorrichtung kann ferner eine Auswertungsschaltung aufweisen zur Auswertung der Eigenschaften des genannten Strompfades in einem Verfahren gemäß einer der oben beschriebenen Ausführungsformen.

Im Folgenden wird die Erfindung mit Hilfe der Figuren anhand von Ausführungsbeispielen näher erläutert. Dabei zeigt:

Figur 1     die Buchsen einer ersten Steckvorrichtung (Kupplung) sowie einen Stecker als zweite Steckvorrichtung mit zu den Buchsen komplementären Steckerstiften;

Figur 2     schematisch einen Strompfad, der eine Buchse, einen Steckerstift, und einen buchsenseitigen Fühler enthält, welcher den Steckerstift innerhalb der Buchse kontaktiert;

Figur 3     schematisch einen Strompfad, der einen Steckerstift, eine Buchse, und einen steckerseitigen Fühler enthält in zwei Ausführungsformen;

Figur 4     schematisch einen Strompfad, der eine Buchse, einen Steckerstift, und zwei buchsenseitige Fühler enthält;

Figur 5     schematisch einen Strompfad, der eine Buchse, einen Steckerstift, und einen buchsenseitigen Fühler enthält, welcher den Steckerstift außerhalb der Buchse kontaktiert;

Figur 6     den Strompfad von Figur 2 mit überlagertem Ersatzschaltbild;

Figur 7     das Ersatzschaltbild für eine direkte Widerstandsmessung;

Figur 8     das Ersatzschaltbild von Figur 7 ergänzt um einen Stromkreis für den Betrieb, eingerichtet für die Messung des Spannungsfalls im Kontaktbereich unter Betriebsbedingungen;

Figur 9     das Ersatzschaltbild von Figur 8 ergänzt um eine Spannungsquelle zur Erzeugung eines Durchschlags (Fritten) im Kontaktbereich eines Fühlers;

Figur 10     eine Aufsicht auf die Anordnung von zwei Kontaktfingern innerhalb und zwei Kontaktfingern außerhalb eines magnetischen Kerns zur Erzeugung einer Induktionsspannung;

Figur 11     die Anordnung von Figur 10 in einer Seitenansicht;

Figur 12     das Ersatzschaltbild zur Anordnung der Figuren 10 und 11;

Figur 13     beispielhafte Verläufe von Realteil und Imaginärteil der Eingangsimpedanz des Systems von Figur 10 und 11 in Abhängigkeit vom Übergangswiderstand im Kontaktbereich;

Figur 14     eine alternative Anordnung eines magnetischen Kerns um einen Steckerstift herum und zwischen zwei Kontaktbereichen;

Figur 15     die Anordnung eines magnetischen Kerns relativ zu einem Steckerstift in einer perspektivischen Ansicht, wobei der magnetische Kern den Kontaktbereich zwischen dem Steckerstift und einem Kontaktfinger der Buchse (nicht dargestellt) umschließen soll;

Figur 16     eine Längsschnitt-Ansicht durch die Anordnung von Figur 15 bei gleichzeitiger Darstellung der Buchse;

Figur 17     einen Schnitt entlang der Linie A von Figur 16;

Figur 18     einen Schnitt entlang der Linie B von Figur 16;

Figur 19     schematisch einen Strompfad, der einen Steckerstift, eine Buchse, und einen buchsenseitigen, angepressten Fühler enthält für eine Messung mit konduktiver und/oder kapazitiver Leitfähigkeit des Strompfades;

Figur 20     schematisch einen Strompfad, der einen Steckerstift, eine Buchse, und einen buchsenseitigen Fühler enthält sowie eine mechanisch mit dem Fühler gekoppelte Detektionsschaltung für den Steckzustand;

Figur 21     eine Abwandlung der Anordnung von Figur 11 mit einer Messspule um den Strompfad.

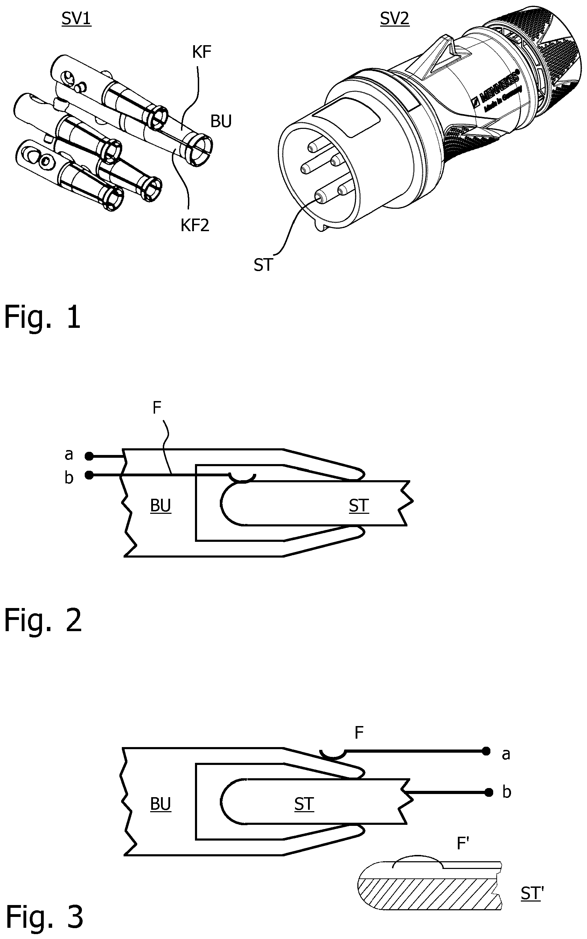

Figur 1 zeigt in einer perspektivischen Ansicht von einer Kupplung als erster Steckvorrichtung SV1 der Übersichtlichkeit halber nur die Buchsen BU. Im dargestellten Beispiel besteht jede der fünf Buchsen BU aus jeweils einer zylindrischen Basis, von der vier parallel abstehende Kontaktfinger KF ausgehen und einen zylindrischen Hohlraum umschließen. Weiterhin zeigt die Figur einen Stecker als zweite Steckvorrichtung SV2 mit zu den Buchsen komplementären Steckerstiften ST. Beim Zusammenstecken des Steckers SV2 mit der Kupplung SV1 kommen die Steckerstifte ST in Kontaktbereichen mit den Buchsen BU elektrisch leitend in Kontakt.

Aufgrund von Alterungsprozessen, Korrosion, Verschmutzung und dergleichen kann ein verhältnismäßig hoher Übergangswiderstand in den Kontaktbereichen entstehen, der zu einem inakzeptabel hohen Anfall von Verlustwärme führt. Daher ist es wünschenswert, die elektrischen Übergangseigenschaften in den Kontaktbereichen zu bestimmen bzw. zu überwachen, insbesondere den Übergangswiderstand im Kontaktbereich zwischen einem Steckerstift ST und der zugehörigen Buchse BU.

Die für eine solche Bestimmung notwendigen Komponenten sollen dabei möglichst nur in einer der beiden Steckvorrichtungen SV1, SV2 untergebracht sein, damit die Überwachung unabhängig von der Art und Herkunft der verwendeten komplementären Steckvorrichtung ist. Bei den meisten nachfolgend beschriebenen Ausführungsbeispielen sind die erforderlichen Komponenten in der Kupplung als erster Steckvorrichtung SV1 untergebracht, während der Stecker als zweite Steckvorrichtung SV2 im Prinzip beliebig sein kann. Die entsprechenden Erläuterungen gelten jedoch (mit den entsprechenden Anpassungen) auch für vertauschte Rollen von Kupplung und Stecker.

Figur 2 zeigt einen schematischen Teilquerschnitt durch ein erstes Kontaktelement in Form einer Buchse BU, in welche als komplementäres zweites Kontaktelement ein Steckerstift ST eingesteckt ist. Die Buchse BU kann eine rundum geschlossene Hülse sein oder aber aus mehreren, parallel von einer Basis abstehenden Kontaktfingern bestehen. Letztere können an ihrem freien, distalen Ende getrennt (vgl. Figur 1) oder elektrisch miteinander verbunden sein. Zwischen dem Steckerstift ST und der Buchse BU bzw. ihren Kontaktfingern gibt es (mindestens) einen Kontaktbereich, über welchen beim Betrieb der elektrische Betriebsstrom fließt. Die Übergangseigenschaften dieses Kontaktbereiches, insbesondere der dort vorliegende Übergangswiderstand, sollen erfindungsgemäß mit in der Kupplung angeordneten Komponenten bestimmt werden.

Der vorstehend beschriebene Aufbau entspricht der Situation bei herkömmlichen Steckvorrichtungen und bildet auch in den nachfolgenden Figuren 3, 4, 5 sowie 19 und 20 die Ausgangsbasis.

Bei der Ausführungsform nach Figur 2 ist ausgehend von dieser Ausgangsbasis vorgesehen, dass am Boden der Buchse BU ein elektrisch leitender Fühler F angeordnet ist, dessen Spitze den Steckerstift ST kontaktiert, wenn dieser ganz in die Buchse eingesteckt ist. Die Berührung erfolgt dabei mit geringer Kontaktnormalkraft, Steck- und Ziehkräfte bleiben nahezu unbeeinflusst. Der Fühler F kann beispielsweise mit Federdraht aus Neusilber oder Bronze realisiert werden (beide Werkstoffe haben sehr gute Federeigenschaften, gute bis sehr gute Korrosionsbeständigkeit, und benötigen nicht zwingend eine Beschichtung). Weiterhin ist der Fühler elektrisch isoliert gegenüber der Buchse BU zu einem Anschluss b nach außen geführt.

Ein zweiter Anschluss a wird zu dem Material der Buchse BU gebildet. Zwischen den Anschlüsse a, b wird somit ein Strompfad gebildet, welcher die folgenden Komponenten enthält:

- die Buchse BU;

- den Steckerstift ST, welcher die Buchse im interessierenden Kontaktbereich kontaktiert;

- den Fühler F, welcher den Steckerstift ST in einem separaten zweiten Kontaktbereich kontaktiert.

An die Anschlüsse a, b kann eine geeignet ausgebildete Auswertungsschaltung (nicht dargestellt) angeschlossen werden, um die Eigenschaften des Strompfades und insbesondere die des interessierenden Kontaktbereiches zu bestimmen.

In Figur 3 ist eine Ausführungsform gezeigt, bei welcher die Messung der Übergangseigenschaften steckerseitig erfolgt. Zu diesem Zweck sind zwei Anschlüsse a, b vorgesehen, von denen der eine (b) mit dem Steckerstift ST verbunden ist und der andere (a) getrennt davon mit einem Fühler F, der im eingesteckten Zustand die Buchse BU von außen kontaktiert.

Der Einsatz in der Figur (unten rechts) zeigt eine alternative Ausführungsform, bei welcher der Steckerstift ST' eine in Axialrichtung verlaufende Aussparung oder Nut aufweist. In dieser Nut ist isoliert vom Steckerstift ST' ein Fühler F' angeordnet, welcher die Buchse BU von innen kontaktieren kann.

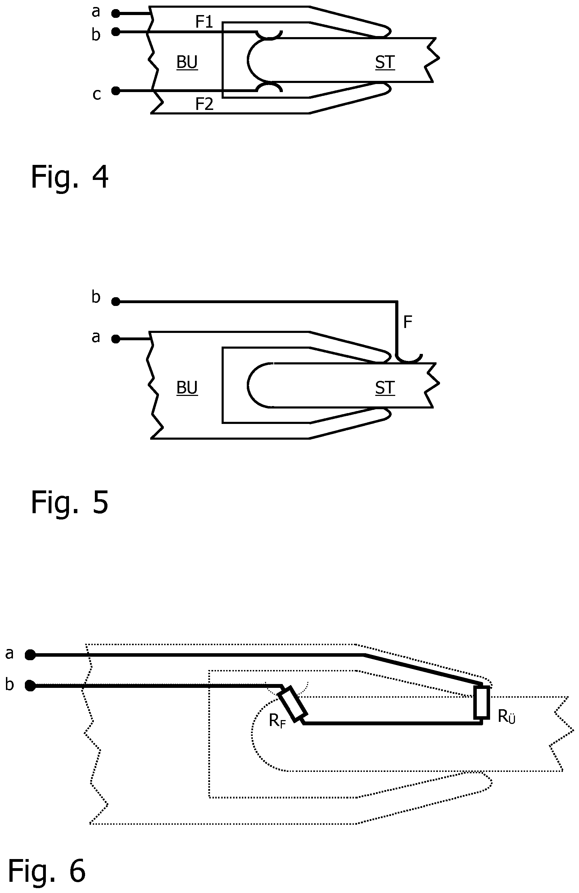

Figur 4 zeigt eine Ausführungsform ähnlich derjenigen von Figur 2, wobei jedoch zusätzlich zu dem ersten Fühler F1 ein zweiter Fühler F2 vorgesehen ist, welcher den Steckerstift ST in einem separaten dritten Kontaktbereich kontaktiert und welcher elektrisch getrennt von der Buchse und dem ersten Fühler F1 zu einem Anschluss c geführt ist. Eine geeignete Auswertungsschaltung kann in diesem Fall Gebrauch von allen drei Anschlüssen a, b, und c machen.

Figur 5 zeigt eine alternative Konstruktion zu Figur 2, bei welcher der Fühler F nicht am Boden der Buchse BU liegt, sondern den Steckerstift ST außerhalb der Buchse kontaktiert.

Figur 6 zeigt ein Ersatzschaltbild des gebildeten elektrischen Strompfades für die Anordnung von Figur 2. Der zwischen den Anschlüssen a und b liegende Strompfad verläuft über die Basis und die Kontaktfinger der Buchse, von dort über den interessierenden Übergangswiderstand $R_Ü$ in den Steckerstift, von diesem über den weiteren Übergangswiderstand $R_F$ im zweiten Kontaktbereich zwischen Steckerstift und Fühler in den Fühler, und endet schließlich im Anschluss b. Innerhalb des Vollmaterials von Buchse bzw. Steckerstift kann der Widerstand in der Regel vernachlässigt werden gegenüber den Übergangswiderständen $R_Ü$, $R_F$ in den Kontaktbereichen.

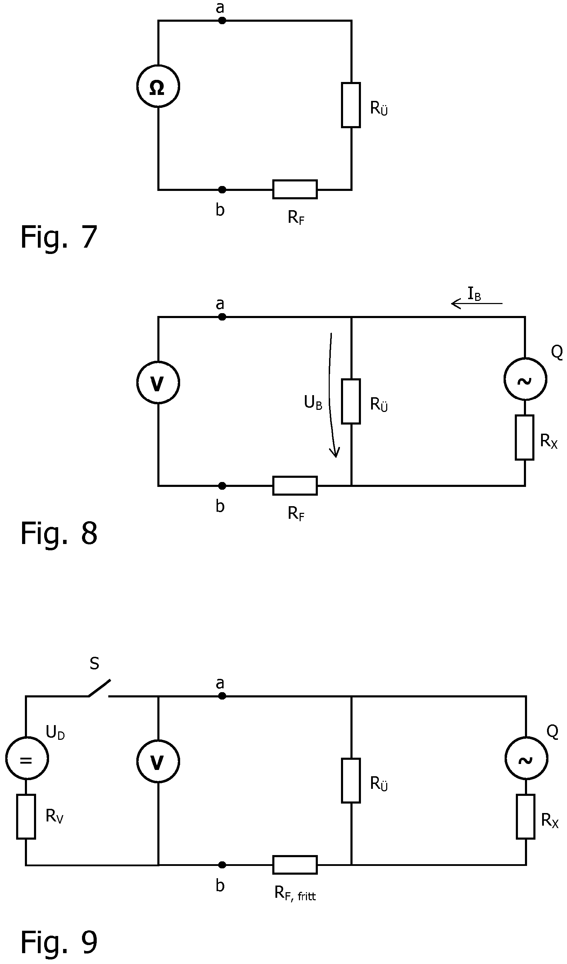

Figur 7 zeigt noch einmal das Ersatzschaltbild aus Figur 6, wobei zusätzlich zwischen den Anschlüssen a und b ein Messgerät angeschlossen ist. Hierbei könnte sich wie in der Figur angedeutet um ein Ohmmeter handeln, mit welchem der Widerstand im Strompfad gemessen wird, der sich im Wesentlichen additiv aus den beiden seriell liegenden Übergangswiderständen $R_Ü$ und $R_F$ zusammensetzt. Da jedoch beide Widerstände vorab unbekannt sind, würde eine solche Messung der Summe ($R_Ü$ + $R_F$) keine Rückschlüsse auf den interessierenden Übergangswiderstand $R_Ü$ erlauben.

Einen Ausweg aus dieser Situation bietet die Anordnung von Figur 4, bei welcher zwei Fühler, F1 und F2, und damit drei (unbekannte) Übergangswiderstände $R_Ü$, $R_{F1}$ und $R_{F2}$ vorhanden sind. Durch die drei unabhängigen Messungen des Gesamtwiderstandes R1 = ($R_Ü$ + $R_{F1}$) zwischen a und b, des Gesamtwiderstandes R2 = ($R_Ü$ + $R_{F2}$) zwischen a und c, sowie des Gesamtwiderstandes R3 = ($R_{F1}$ + $R_{F2}$) zwischen b und c kann dann jedoch der interessierende Übergangswiderstand $R_Ü$ bestimmt werden als $R_Ü$ = (R1 +R2-R3)/2. Voraussetzung hierfür ist, dass sich die drei Übergangswiderstände R1, R2, R3 mit hinreichender Genauigkeit messen lassen.

Figur 8 illustriert ein weiteres Messprinzip, welches mit einem einzigen Fühler (s. Figuren 2, 3, 5) auskommt und welches im Betriebszustand der Steckvorrichtung ausgeführt wird. Diesbezüglich ist im rechten Teil der Figur der Betriebsstromkreis angedeutet, welcher eine Wechselspannungsquelle Q, den interessierenden Übergangswiderstand $R_Ü$, sowie einen Verbraucher $R_X$ enthält. Der in diesem Stromkreis fließende Betriebsstrom $I_B$ erzeugt am Übergangswiderstand $R_Ü$ einen Spannungsfall $U_B$. Letzterer kann mit einem Voltmeter an den Anschlüssen a, b gemessen werden.

Der unbekannte Übergangswiderstand $R_F$ zwischen dem Fühler und dem Steckerstift stört bei einer solchen Spannungsmessung nicht, wenn er ausreichend klein ist im Vergleich zum Innenwiderstand des Voltmeters. Denn der im Betriebsstromkreis erzeugte Spannungsfall $U_B$ am Übergangswiderstand $R_Ü$ erzeugt einen Messstrom über den Anschluss a, das Voltmeter, den Anschluss b, und den Übergangswiderstand $R_F$, welcher aufgrund des hohen Innenwiderstandes im Voltmeter klein ist. Zudem sorgt ein hoher Innenwiderstand im Vergleich zum Übergangswiderstand $R_F$ dafür, dass im Wesentlichen die gesamte Spannung am Voltmeter abfällt.

Figur 9 zeigt eine Erweiterung der Schaltung von Figur 8, mit welcher die erwähnte Bedingung erreicht werden kann, dass der Übergangswiderstand $R_F$ am Fühler klein sein soll im Vergleich zum Innenwiderstand des Voltmeters. Dazu wird über einen Schalter S eine Durchschlagspannung $U_D$ ausreichender Höhe an die Anschlüsse a und b gelegt. Im Einzelnen kann folgender beispielhafter Ablauf vorliegen:

Zunächst wird für die Dauer von ca. 1 Sekunde der Schalter S geschlossen ("Phase 1"). Eine Spannung $U_D$ von ca. 50 V bewirkt, dass auch an gealterten Kontakten vorhandene isolierende Oxide, Fremdschichten etc. durchschlagen beziehungsweise gefrittet werden, so dass anschließend über den Kontakt und über einen Vorwiderstand $R_V$ von ca. 500 Ω ein Strom von ca. 100 mA (= 50 V / 500 Ω) fließt. Nach dem Durchschlag / der Frittung liegt die Spannung am Übergang zwischen Fühler und Steckerstift maximal in der Größenordnung der Schmelzspannung des Materials der Kontaktoberfläche. Beispielsweise für Nickel beträgt die Schmelztemperatur 1453°C und die zugehörige Schmelzspannung 0.65 V. Der so durch das Fritten geschaffene Übergangswiderstand $R_{F,fritt}$ Fühler-Steckerstift liegt somit in der Größenordnung von 1 V / 100 mA = 10 Ω.

Zur Kontrolle kann bei geschlossenem Schalter S eine Spannungsmessung erfolgen. Im Übrigen dient Phase 1 lediglich dazu, einen Übergangswiderstand $R_{F,fritt}$ zwischen dem Fühler und dem Steckerstift herzustellen, der um mindestens eine Größenordnung niedriger ist als der hohe Innenwiderstand, mit dem die Spannungsmessung erfolgt.

Zu Beginn der anschließenden "Phase 2" wird der Schalter S geöffnet. Eine Spannungsmessung liefert nun während des Betriebs der Steckvorrichtung den gesuchten Spannungsfall $U_B$ zwischen Steckerstift und Buchse.

Ist von anderer Stelle der Betriebsstrom $I_B$ bekannt, so kann eine Auswertungsschaltung aus Spannungsfall $U_B$ und Strom $I_B$ den Übergangswiderstand $R_Ü$ berechnen. Aber auch ohne Kenntnis des Betriebsstromes stellt der Spannungsfall eine wertvolle Information dar: Bei einer Steckvorrichtung kann bei einem Spannungsfall Steckerstift-Buchse von beispielsweise bis zu 25 mV noch von einem stabilen Betrieb gesprochen werden, spätestens ab ca. 50 mV der dauerhafte Betrieb jedoch infrage gestellt sein (bei einer 125 A-Steckvorrichtung entspricht dies einem Übergangswiderstand Steckerstift-Buchse von 0.4 mΩ; andere Grenzwerte für die Spannung sind möglich).

Da das entscheidende Merkmal die Messung des Spannungsfalls in Phase 2 ist, kann bei entsprechend robuster Auslegung des Fühlers gegebenenfalls auf Phase 1 gänzlich verzichtet werden.

Auf Phase 2 kann unmittelbar wieder Phase 1 folgen. Zwischen beiden Phasen kann jedoch ebenso eine Ruhephase ("Phase 3") eingelegt werden.

Ein alternativer Ablauf einer Messung bei einer Anordnung mit zwei Fühlern kann (unter Bezugnahme auf Figur 4) wie folgt aussehen:

Phase 1: Kurzeitiger Strom über a und b zum "Vorbereiten" des Überganges zwischen erstem Fühler F1 und Steckerstift ST.

Phase 2: Über die Anschlüsse a (Buchse BU) und c (zweiter Fühler F2) wird kurzzeitig ein Strom eingeprägt, der in der Größenordnung des späteren Betriebsstromes (über Buchse BU und Steckerstift ST) liegt. Dabei wird der Spannungsfall zwischen a und b (erster Fühler F1) gemessen.

Phase 3: Falls Phase 2 ein "in Ordnung" ergeben hat, wird z.B. über ein Schütz die Betriebsspannung/der Betriebsstrom zugeschaltet. Anderenfalls erfolgt eine Warnmeldung.

Das Verfahren kann somit dazu benutzt werden, vor Zuschalten des Betriebsstromes die Eigenschaften des Überganges Steckerstift-Hülse zu prüfen.

Ein Vorteil der beschriebenen Verfahren ist, dass sie unabhängig von der Kontaktierungsweise Steckerstift-Buchse funktionieren ("X-Contact" gemäß WO 2016/184673 A1, Torsionsfeder, etc.). Weiterhin können sie während des laufenden Betriebes ausgeführt werden, und der Betriebsstrom verfälscht keine Messwerte.

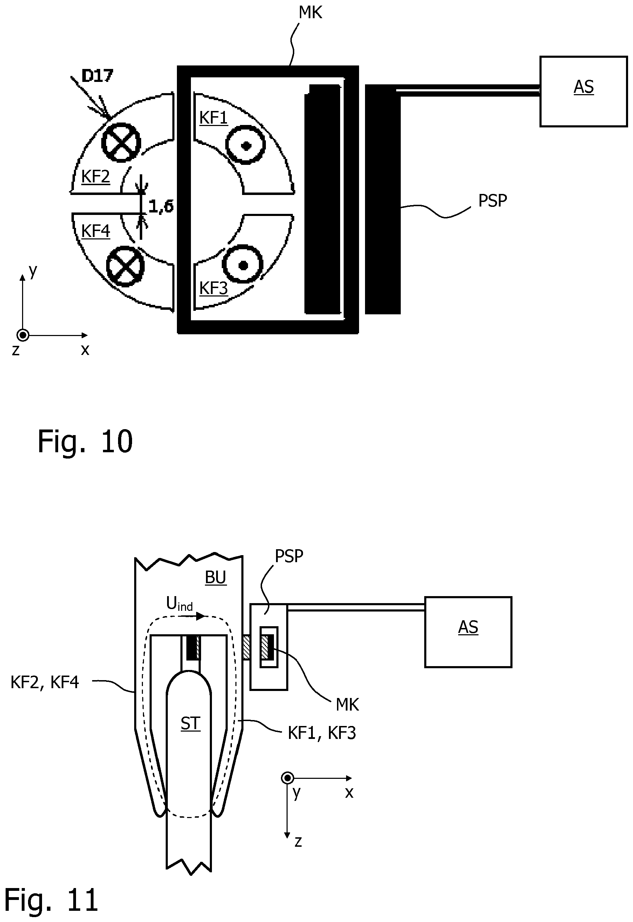

In den Figuren 10-18 ist ein weiteres Verfahren illustriert, bei welchem eine in einem Strompfad induzierte Spannung zum Einsatz kommt. Ein solches Verfahren lässt sich insbesondere mit den in Figur 1 dargestellten Buchsen BU durchführen, bei denen an einer gemeinsamen Basis zwei (oder mehr) Kontaktfinger KF parallel zueinander stehen, ohne sich am distalen Ende zu kontaktieren.

Figur 10 zeigt eine schematische Aufsicht auf eine Buchse BU mit vier separaten Kontaktfingern KF1, KF2, KF3, und KF4, die sich über einen Kreisringsektor von jeweils ca. 90° erstrecken. Beispielhafte Abmessungen (Durchmesser, Spaltabstand) sind in mm eingetragen. Zwei dieser Kontaktfinger, KF1 und KF3, sind von einem weichmagnetischen Kern MK ( z.B. aus nanokristallinem oder amorphem Material, einem Ferrit oder einem ähnlichen Magnetwerkstoff) umschlungen, wobei der umlaufend geschlossene Kern MK seinerseits an einem außerhalb der Buchse liegenden Abschnitt von einer mehrlagigen Primärspule PSP, beispielsweise aus lackiertem Kupferdraht, umwickelt ist. Die Primärspule PSP ist mit einer Auswertungsschaltung AS verbunden, über welche geeignete Strom- und/oder Spannungsverläufe aufgeprägt werden können.

Nach dem Prinzip eines Transformators erzeugen Stromschwankungen in der Primärspule PSP ein sich änderndes magnetischen Feld, welches vom Kern MK gebündelt und weitergeleitet wird. Wie aus der Seitenansicht von Figur 11 erkennbar ist, bilden die vom Kern MK umschlossenen Kontaktfinger KF1 und KF3 und die externen Kontaktfinger KF2 und KF4 vermöge des eingesteckten Steckerstiftes ST einen geschlossenen Strompfad um den Kern MK herum, der auch als Sekundärspule mit einer Windung aufgefasst werden kann. Das wechselnde Magnetfeld im Kern MK führt daher innerhalb dieses Strompfades zu einer Induktionsspannung $U_{ind}$ und damit zu entsprechenden Induktionsströmen (s. die in Figur 10 angedeuteten Pfeilspitzen in den Kontaktfingern KF1, KF3 und Pfeilenden in den Kontaktfingern KF2 und KF4). Diese Induktionsströme müssen über die Kontaktbereiche zwischen den Kontaktfingern und dem Steckerstift ST fließen und stellen somit den gewünschten Sensor für die

Übergangseigenschaften bzw. den Übergangswiderstand in den Kontaktbereichen dar.

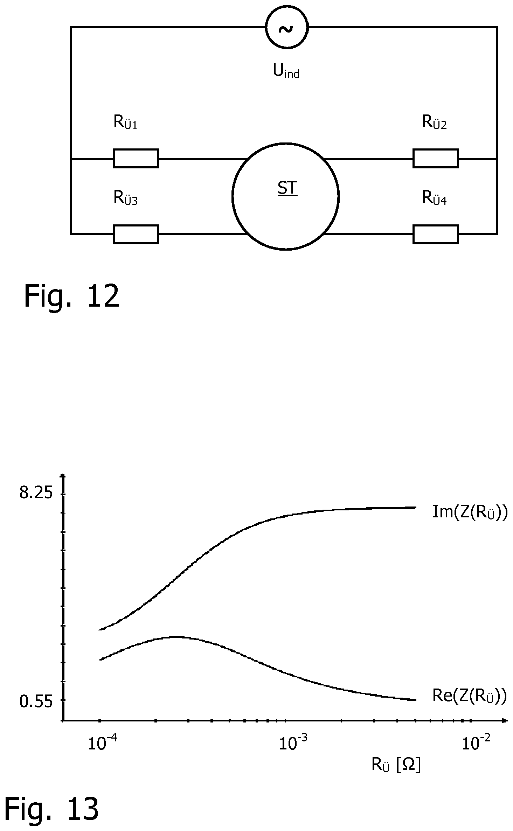

Bei dem beschriebenen Aufbau handelt es sich letztendlich um zwei in Reihe geschaltete Parallelschaltungen von jeweils zwei Kontaktfingern gemäß dem Ersatzschaltbild von Figur 12, wobei die Materialwiderstände der Einfachheit halber vernachlässigt wurden. Der Gesamtwiderstand in diesem Induktions-Stromkreis der "Sekundärspule" berechnet sich mit

$$R_{13} = R_{Ü1}R_{Ü3} / (R_{Ü1} + R_{Ü3})$$

$$R_{24} = R_{Ü2}R_{Ü4} / (R_{Ü2} + R_{Ü4})$$

als

$$R_{ges,ind} = R_{13} + R_{24}$$

Im Unterschied zu der Schaltung von Figur 12 liegt im üblichen Betrieb der Steckvorrichtung eine Parallelschaltung der Kontaktfinger vor. Deren Gesamtwiderstand beträgt dann

$$R_{ges,B} = R_{13}R_{24} / (R_{13} + R_{24})$$

Falls alle vier Übergangswiderstände gleich groß sind, also

$$R_{Ü1} = R_{Ü2} = R_{Ü3} = R_{Ü4} = R_{Ü},$$

gilt $R_{ges,ind} = R_{Ü}$ und $R_{ges,B} = R_{Ü}/4$, also $R_{ges,B} = R_{ges,ind}/4$.

Falls die vier Übergangswiderstände ungleiche Werte annehmen (in der Praxis statistisch verteilt), so kann der mit dem hier beschriebenen Verfahren ermittelte Messwert $R_{ges,ind}$ den Wert von $R_{ges,B}$ überschreiten, liegt somit aber "auf der sicheren Seite".

In einem abgewandelten Ansatz könnte die Auswerteschaltung AS an der Primärwicklung PSP derart gestaltet werden, dass mit ihr nicht nur die komplexe Eingangsimpedanz Z und somit $R_{ges,ind}$ bestimmt wird, sondern mit $I_{B13}$ außerdem der Anteil des Betriebsstromes $I_B$ gemessen wird, der über die vom magnetischen Kern MK eingeschlossenen Kontaktfinger KF1 und KF3 in Fig. 10 fließt (vgl.

Transformator/Stromwandlerprinzip). Ist der Auswerteschaltung außerdem der Strom $I_{B24}$ über die anderen Kontaktfinger KF2, KF4 oder der Betriebsstrom $I_B$ selbst bekannt (beispielsweise durch Messung), so lassen sich folgende Beziehungen ausnutzen:

$$I_B = I_{B13} + I_{B24}$$

$$I_{B24}R_{24} = I_{B13}R_{13}$$

$$R_{ges,ind} = R_{13} + R_{24}$$

$$R_{ges,B} = R_{13}R_{24} / (R_{13} + R_{24})$$

Die letzten beiden Beziehungen wurden zuvor bereits genutzt. Löst man dieses Gleichungssystem nach $R_{ges,B}$ auf, so führt dies zu

$$R_{ges,B} = R_{ges,ind} \, IB_{13} \, IB_{24} / (IB_{13} + IB_{24})^2$$

Anhand dieser Formel kann die Auswerteschaltung AS nicht nur Information über $R_{ges,B}$, sondern $R_{ges,B}$ selbst liefern.

Für eine Ermittlung von $R_{ges,ind}$ wird von der Auswertungsschaltung AS der Figuren 10, 11 die (komplexe) Eingangsimpedanz Z der Primärspule PSP gemessen, welche unter anderem von $R_{ges,ind}$ abhängt.

Figur 13 zeigt diesbezüglich das Ergebnis einer Simulation mit typischen Parametern für die eingesetzten Komponenten. Dargestellt sind dabei der Realteil $Re(Z(R_Ü))$ und der Imaginärteil $Im(Z(R_Ü))$ der komplexen Eingangsimpedanz Z in Abhängigkeit vom Übergangswiderstand $R_Ü$ (unter obiger Annahme, dass alle einzelnen Übergangswiderstände gleich groß sind). Die Grafik verdeutlicht, dass sich die Eingangsimpedanz Z des Messkreises bei Änderungen des Übergangswiderstandes $R_Ü$ signifikant ändert. Eine an den Messkreis angeschlossene Auswertungsschaltung AS kann daher anhand der Eingangsimpedanz den gesuchten Übergangswiderstand ermitteln.

Bei der Simulation wurde angenommen, der magnetische Kern MK sei so beschaffen, dass bei einer Erregung mit 127 A die magnetische Flussdichte von 1 Tesla erreicht wird. Bei noch stärkerer Erregung ist allmählich mit Sättigung des Magnetkreises zu rechnen. Diese Sättigung kann beispielsweise auftreten, wenn bei Schweranlauf über mehrere Sekunden Ströme deutlich oberhalb des Nennstromes fließen, von denen ca. die Hälfte auf die vom Kern eingeschlossenen beiden Kontaktfinger entfällt. Die nachgeschaltete Elektronik wird folglich im Bereich des Betriebsstromscheitelwertes verfälschte Z-Werte messen, in der Nähe des Betriebsstromnulldurchganges jedoch sinnvolle Werte detektieren. Optional kann daher die Auswertungsschaltung AS so ausgelegt werden, dass sie eine Messung synchronisiert mit dem Betriebsstrom (50 Hz) durchführt, insbesondere nur nahe dem Nulldurchgang des Betriebsstromes.

Das beschriebene Verfahren mit der Induktion eines Messstromes kann optional auch unter Verwendung eines Fühlers ausgeführt werden. Beispielsweise könnte ein Fühler F gemäß Figur 2 die Rolle der außerhalb (oder innerhalb) des magnetischen Kerns liegenden Kontaktfinger übernehmen. Des Weiteren könnte an die Stelle mehrerer Kontaktfinger auch ein geteilter Steckerstift treten.

Das den obigen Ansätzen zugrundeliegende Prinzip besteht darin, dass per Induktion mit Hilfe eines magnetischen Kerns die Kontaktstellen zwischen Buchse und Steckerstift untersucht werden können, wenn ein geschlossener durch elektrisch leitfähiges Material führender Weg (Kurve, Linie), der die von dem magnetischen Kern aufgespannte Fläche durchtritt, nur unter gleichzeitiger Beteiligung von Kontaktelementen der ersten und der zweiten Steckvorrichtung gebildet werden kann.

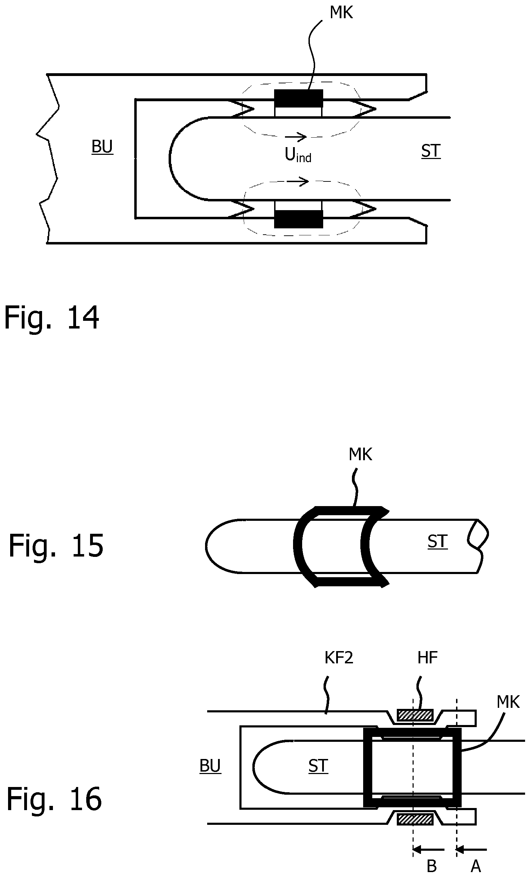

Diese Bedingungen können außer wie bereits dargestellt auch in alternativen Konstellationen erreicht werden (Anmerkung: Der Übersichtlichkeit halber sind die Windungen einer Primärwicklung, die den magnetischen Kern ähnlich wie bei einem Transformator umschlingen, in den Figuren 14 bis 18 nicht dargestellt).

So zeigt Figur 14 die Anordnung eines magnetischen Kerns MK, der innerhalb einer Buchse BU um einen Steckerstift ST herum verläuft, wobei in Axialrichtung an beiden Seiten neben dem Kern MK Kontaktbereiche zwischen Steckerstift ST und Buchse BU vorliegen. Ein Strompfad der gewünschten Art verläuft dann vom Steckerstift ST über einen ersten der Kontaktbereiche Steckerstift/Buchse in die Buchse BU (bzw. ihren Kontaktfinger), und von dort über den zweiten der Kontaktbereiche Steckerstift/Buchse zurück in den Steckerstift ST.

Ein weiterer Ansatz ist in den Figuren 15 bis 18 dargestellt. Hierbei verläuft effektiv nur der Kontaktbereich zwischen Steckerstift ST und Buchse BU durch die Fläche des magnetischen Kerns MK.

Wie aus der perspektivischen Ansicht von Figur 15 erkennbar ist, schmiegt sich die Form des in Aufsicht rechteckigen magnetischen Kerns MK halbzylindrisch an den Steckerstift ST an.

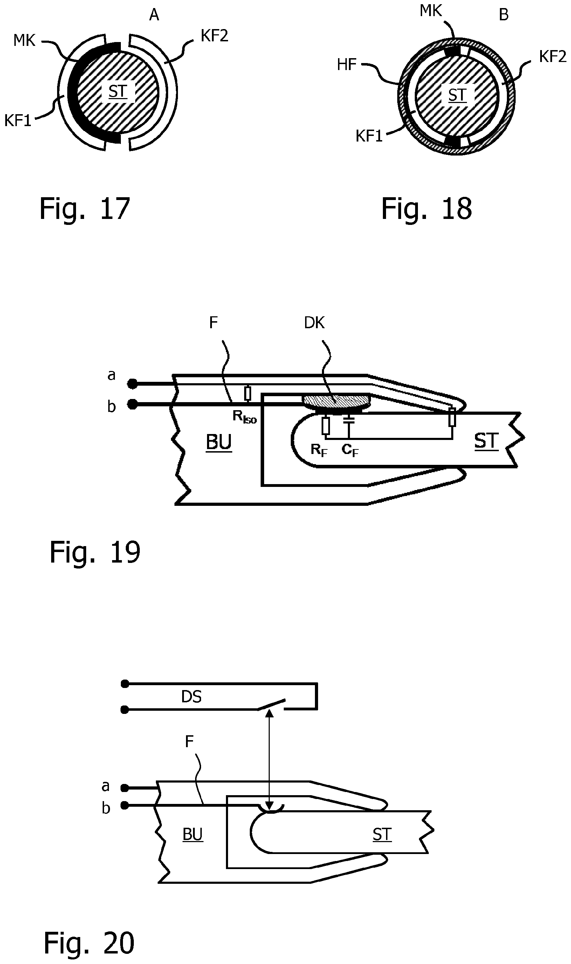

In der axialen Schnittansicht von Figur 16 erscheint diese dreidimensionale Form des magnetischen Kerns MK als Rechteck. In Figur 16 ist weiterhin die Buchse BU dargestellt, welche zwei parallele Kontaktfinger KF1 und KF2 aufweist. Im Bereich einer um 360° umlaufenden äußeren Hülsenfeder HF berühren die Kontaktfinger KF1, KF2 den Steckerstift ST jeweils in einem ersten bzw. zweiten Kontaktbereich. Der erste dieser beiden Kontaktbereiche, zwischen dem ersten Kontaktfinger KF1 und dem Steckerstift ST (links in Figur 18 im Querschnitt entlang der Linie "B"), wird von dem magnetischen Kern MK umschlossen.

Der Strompfad, in dem die gewünschte Induktionsspannung erzeugt wird, verläuft vom Steckerstift ST über den ersten Kontaktbereich KF1/ST, durch den ersten Kontaktfinger KF1, über den Boden der Buchse BU und/oder die Hülsenfeder HF in den zweiten Kontaktfinger KF2, von dort über den zweiten Kontaktbereich KF2/ST zurück in den Steckerstift ST.

Ein Vorteil dieser Ausführungsform ist, dass sie sowohl bei Buchsen mit freistehenden Kontaktfingern als auch (wie dargestellt) bei Buchsen mit distal verbundenen Kontaktfingern anwendbar ist.

Bei den bisher vorgestellten Beispielen wurde nicht weiter diskutiert, ob die betrachteten Strompfade durchgehend konduktiv oder (nur) kapazitiv leitend waren. Alle Beispiele funktionieren jedenfalls mit einer konduktiven Leitfähigkeit, bei welcher ein dauerhafter Gleichstrom durch den Strompfad geleitet werden kann.

Es ist jedoch auch möglich, dass ein betrachteter Strompfad an mindestens einer Stelle nur kapazitiv leitend ist, also eine Kapazität in Serienschaltung enthält. Ein solcher Strompfad kann keinen dauerhaften Gleichstrom leiten, sondern nur Wechselstrom. Davon abgesehen funktionieren die beschriebenen Beispiele jedoch unverändert.

Die Ausnutzung eines gegebenenfalls nur kapazitiv leitenden Strompfades ist in Figur 19 illustriert. Diese zeigt schematisch ein Strompfad, der einen Steckerstift ST, eine Buchse BU, und einen buchsenseitigen Fühler F enthält. Im Unterschied zur Anordnung von Figur 2 ist ein elektrisch isolierendes

Druckkissen DK innerhalb der Buchse BU vorgesehen, welches den Fühler F an den Steckerstift ST anpresst. Auf diese Weise soll eine ausreichend enge Berührung zwischen Fühler F und Steckerstift ST garantiert werden. Selbst wenn daher Oxidschichten oder dergleichen eine konduktive elektrische Leitung vom Fühler F zum Steckerstift ST verhindern sollten, wird zwischen Fühler F und Steckerstift ST eine ausreichend hohe Kapazität ausgebildet, die einen verwertbar hohen (Wechsel-)Stromfluss im Strompfad zulässt. Maßnahmen wie beispielsweise das beschriebene Fritten des Kontaktes wären daher nicht erforderlich.

Das elektrische Ersatzschaltbild einer solchen Anordnung ist in Figur 19 überlagert dargestellt, wobei $C_F$ die Kapazität und $R_F$ der ohmsche Widerstand zwischen Fühler F und Steckerstift ST ist. $R_{Iso}$ bezeichnet den Isolationswiderstand zwischen dem Fühler F und der Buchse BU und liegt typischerweise in der Größenordnung von mindestens 5 MΩ.

Optional können bei einer solchen Ausführungsform in einer separaten Messung zunächst nur die Verhältnisse am Übergang zwischen Fühler F und Steckerstift ST ermittelt werden, also $C_F$ und $R_F$, beispielsweise durch eine Messung ohne Betriebsstrom und/oder eine Messung ohne eingesteckten Steckerstift ST. Das Ergebnis dieser Ermittlung kann dann in der Durchführung und/oder Auswertung der anschließenden eigentlichen Messung einfließen, um deren Zuverlässigkeit zu verbessern.

Eine andere Erweiterung der Erfindung ist in Figur 20 illustriert. Bei diesem Ansatz geht es um eine unabhängige Detektion des Zustandes, dass überhaupt ein Steckerstift ST in die Buchse BU eingesteckt ist. Damit wird es möglich, die Fälle "kein Steckerstift eingesteckt" und "unendlich hoher Übergangswiderstand" zu unterscheiden.

Vorzugsweise erfolgt die Detektion des Steckzustandes mechanisch, um von der Stromführung unabhängig zu sein. Wie in Figur 20 angedeutet kann der Fühler F beispielsweise mechanisch mit dem Schalter einer Detektionsschaltung DS gekoppelt sein. Durch die Berührung eines eingesteckten Steckerstiftes ST wird der Fühler F bewegt, und diese Bewegung wird mechanisch in ein Öffnen (oder Schließen) des Schalters der Detektionsschaltung DS umgesetzt. Der Schalterzustand kann dann wiederum von außen abgefragt werden.

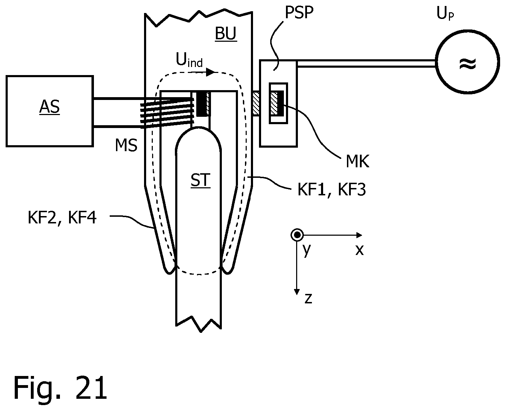

Figur 21 zeigt eine Abwandlung der Anordnung von Figur 11, wobei nachfolgend nur die Unterschiede beschrieben werden und im Übrigen auf die obige Beschreibung verwiesen wird.

In der abgewandelten Anordnung wird wiederum über die Primärspule PSP ein magnetisches Wechselfeld im magnetischen Kern MK induziert, indem eine Wechselspannungsquelle Up an die Primärspule PSP angeschlossen wird (diese Wechselspannungsquelle ist in Figur 11 ein nicht näher dargestellter Teil der dortigen Auswertungsschaltung AS).

Die (Rück-)Wirkungen eines vom magnetischen Wechselfeld des Kerns im interessierenden Strompfad induzierten Stromflusses werden in dieser Anordnung allerdings nicht mehr über die Primärspule PSP erfasst. Stattdessen ist um den Strompfad eine weitere Spule angeordnet, welche als Messspule MS mit der Auswertungsschaltung AS verbunden ist. In der Messspule MS wird direkt durch den Stromfluss im Strompfad, welchen sie umgibt, eine messbare elektrische Größe (z.B. Spannung) induziert.

Durch die Messspule MS kann dabei wie in der Figur angedeutet der gesamte Strompfad verlaufen, wenn die Messspule MS alle Kontaktfinger einer Stromrichtung (hier KF2 und KF4 oder KF1 und KF3) umschließt. Alternativ könnte aber auch nur ein Teil des Strompfades erfasst werden, beispielsweise wenn die Messspule MS nur um einen einzigen Kontaktfinger liefe.

**Patentansprüche**

1. Verfahren zur Bestimmung der elektrischen Übergangseigenschaften ($R_Ü$) im Kontaktbereich zwischen einem ersten Kontaktelement (BU) einer ersten Steckvorrichtung (SV1) und einem dazu komplementären zweiten Kontaktelement (ST) einer zweiten Steckvorrichtung (SV2),

> wobei das erste Kontaktelement eine Buchse (BU) und das zweite Kontaktelement ein Steckerstift (ST) ist oder umgekehrt, und
> wobei die Eigenschaften eines Strompfades ausgewertet werden, welcher das erste Kontaktelement (BU), den Kontaktbereich, und von der zweiten Steckvorrichtung (SV2) nur das zweite Kontaktelement (ST) enthält; **dadurch gekennzeichnet, dass**
>
> > - der Strompfad geschlossen ist und nur das erste Kontaktelement (BU), den Kontaktbereich, und das zweite Kontaktelement (ST) enthält;
> > - in dem Strompfad eine Induktionsspannung ($U_{ind}$) erzeugt wird, mit deren Hilfe Messungen im Strompfad gemacht werden, welche Rückschlüsse auf die interessierenden Übergangseigenschaften ermöglichen.

2. Verfahren nach dem Oberbegriff von Anspruch 1, insbesondere Verfahren nach Anspruch 1, **dadurch gekennzeichnet, dass**

> - der Strompfad mindestens zwei Fühler (F, F1, F2) enthält, welche in der ersten Steckvorrichtung (SV1) angeordnet sind und im zusammengesteckten Zustand das zweite Kontaktelement (ST) mit jeweils eigenem und separatem Kontaktbereich berühren;
>
> wobei
>
> > a) drei oder mehr Strompfade ausgewertet werden, welche unterschiedliche Kombinationen der mindestens drei Kontaktbereiche enthalten, die zwischen (i) dem zweiten Kontaktelement und (ii) dem ersten Kontaktelement und/oder den verschiedenen Fühlern gebildet werden, und/oder
> > b) ein Strom über das erste Kontaktelement (BU), das zweite Kontaktelement (ST) und einen der Fühler (F2) eingeprägt wird, wobei der Spannungsfall zwischen dem ersten Kontaktelement (BU) und dem anderen Fühler (F1) gemessen wird.

3. Verfahren nach dem Oberbegriff von Anspruch 1, insbesondere Verfahren nach mindestens einem der vorhergehenden Ansprüche, **dadurch gekennzeichnet, dass** die Auswertung mit dem Verlauf eines Betriebs-Wechselstromes ($I_B$)

über den Kontaktbereich synchronisiert wird, indem Messungen bevorzugt im Bereich der Nulldurchgänge des Betriebs-Wechselstromes vorgenommen werden.

4. Verfahren nach dem Oberbegriff von Anspruch 1, insbesondere Verfahren nach mindestens einem der vorhergehenden Ansprüche, wobei der Strompfad mindestens einen Fühler (F, F1, F2) enthält, welcher in der ersten Steckvorrichtung (SV1) angeordnet ist und im zusammengesteckten Zustand das zweite Kontaktelement (ST) berührt, **dadurch gekennzeichnet, dass** der Strompfad zwischen dem Fühler (F, F1, F2) und dem zweiten Kontaktelement (ST) nur kapazitiv leitend ist und dort eine Kapazität von mehr als ca. 10 pF ausgebildet ist, die einen Wechselstromfluss im Strompfad zulässt.

5. Verfahren nach mindestens einem der vorhergehenden Ansprüche, **dadurch gekennzeichnet, dass** über den Strompfad der Spannungsfall ($U_B$) gemessen wird, der bei Fluss eines Betriebsstromes ($I_B$) über den Kontaktbereich auftritt.

6. Verfahren nach mindestens einem der vorhergehenden Ansprüche, **dadurch gekennzeichnet, dass** definierte Übergangseigenschaften zwischen dem Fühler (F, F1, F2) und dem zweiten Kontaktelement (ST) hergestellt werden, vorzugsweise durch Anlegen einer Durchschlagspannung ($U_D$).

7. Verfahren nach mindestens einem der vorhergehenden Ansprüche, **dadurch gekennzeichnet, dass** der Strompfad die Sekundärspule an einem magnetischen Kern (MK) bildet, an welchem weiterhin eine Primärspule (PSP) angeordnet ist.

8. Verfahren nach mindestens einem der vorhergehenden Ansprüche, **dadurch gekennzeichnet, dass** der Strompfad mindestens zwei Kontaktfinger (KF1, KF2, KF3, KF4) enthält, welche beide denselben Kontaktstift (ST) kontaktieren.

9. Steckvorrichtung (SV1) mit mindestens einem ersten Kontaktelement (BU), welche ein komplementäres zweites Kontaktelement (ST) einer zweiten Steckvorrichtung (SV2) in zusammengestecktem Zustand in einem Kontaktbereich kontaktiert,

> wobei das erste Kontaktelement eine Buchse (BU) und das zweite Kontaktelement ein Steckerstift (ST) ist oder umgekehrt, und wobei die Steckvorrichtung (SV1) einen Strompfad aufweist, welcher das erste Kontaktelement (BU), den Kontaktbereich, und von der zweiten Steckvorrichtung (SV2) nur das komplementäre zweite Kontaktelement (ST) enthält, **dadurch gekennzeichnet, dass**

- der Strompfad geschlossen ist und nur das erste Kontaktelement (BU), den Kontaktbereich, und das zweite Kontaktelement (ST) enthält;
- sie Mittel zur Erzeugung einer Induktionsspannung ($U_{ind}$) für ein Verfahren nach Anspruch 1 enthält.

10. Steckvorrichtung nach dem Oberbegriff von Anspruch 9, **dadurch gekennzeichnet, dass** sie mindestens zwei Fühler (F, F1, F2) enthält, welche im zusammengesteckten Zustand ein komplementäres zweites Kontaktelement (ST) der zweiten Steckvorrichtung (SV2) mit jeweils eigenem und separatem Kontaktbereich berühren und sie Mittel zum Ausführen eines Verfahrens nach Anspruch 2 enthält.

11. Steckvorrichtung nach Anspruch 9 oder 10, **dadurch gekennzeichnet, dass** sie einen magnetischen Kern (MK) enthält, welcher das erste Kontaktelement (BU) und/oder einen Fühler (F) und/oder den Kontaktbereich umgibt.

12. Steckvorrichtung nach mindestens einem der Ansprüche 9, 10 oder 11, **dadurch gekennzeichnet, dass** sie eine Auswertungsschaltung (AS) zur Auswertung der Eigenschaften eines Strompfades nach einem Verfahren gemäß einem der Ansprüche 1 bis 8 enthält.

**Claims**

1. Method for the determination of the electrical transition properties ($R_ü$) in the contact region between a first contact element (BU) of a first plug device (SV1) and a second contact element (ST), being complementary with the first contact element, of a second plug device (SV2),

wherein the first contact element is a socket (BU) and the second contact element is a plug pin (ST) or vice versa, and wherein the properties of a current path are evaluated, which current path includes the first contact element (BU), the contact region, and from the second plug device (SV2) only the second contact element (ST); **characterized in that**

- the current path is closed and includes only the first contact element (BU), the contact region, and the second contact element (ST);
- an induction voltage ($U_{ind}$) is generated in the current path, with the aid of which measurements are made in the current path to allow conclusions about the transition properties of interest.

2. Method according to the preamble of claim 1, in particular method according to claim 1, **characterized in that**

- the current path includes at least two sensors (F, F1, F2), which are arranged in the first plug device (SV1) and contact the second contact element (ST) each with its own and separate contact region when plugged together; wherein

a) three or more current paths are evaluated which include different combinations of the at least three contact regions formed between (i) the second contact element and (ii) the first contact element and/or the different sensors, and/or
b) a current is injected via the first contact element (BU), the second contact element (ST) and one of the sensors (F2), wherein the voltage drop between the first contact element (BU) and the other sensor (F1) is measured.

3. Method according to the preamble of claim 1, in particular method according to at least one of the preceding claims, **characterized in that** the evaluation is synchronized with the course of an operating alternating current ($I_B$) across the contact region by preferentially carrying out measurements in the range of the zero-crossings of the operating alternating current.

4. Method according to the preamble of claim 1, in particular method according to at least one of the preceding claims,

wherein the current path includes at least one sensor (F, F1, F2) which is arranged in the first plug device (SV1) and contacts the second contact element (ST) when plugged together, **characterized in that** the current path between the sensor (F, F1, F2) and the second contact element (ST) is only capacitively conductive and a capacitance of more than about 10 pF is formed there, which permits an alternating current flow in the current path.

5. Method according to at least one of the preceding claims, **characterized in that** the voltage drop ($U_B$) is measured, via the current path, that occurs when an operating current ($I_B$) flows across the contact region.

6. Method according to at least one of the preceding claims, **characterized in that** defined transition properties are established between the sensor (F, F1, F2) and the second contact element (ST), preferably by applying a breakdown voltage ($U_D$).

7. Method according to at least one of the preceding claims, **characterized in that** the current path forms the secondary coil on a magnetic core (MK), on which a primary coil (PSP) is also arranged.

8. Method according to at least one of the preceding claims, **characterized in that** the current path includes at least two contact fingers (KF1, KF2, KF3, KF4), which both contact the same contact pin (ST).

9. Plug device (SV1) including at least one first contact element (BU), which contacts in a contact region a complementary second contact element (ST) of a second plug device (SV2) when plugged together, wherein the first contact element is a socket (BU) and the second contact element is a plug pin (ST) or vice versa, and and wherein the plug device (SV1) has a current path which includes the first contact element (BU), the contact region, and from the second plug device (SV2) only the complementary second contact element (ST), **characterized in that**

    - the current path is closed and includes only the first contact element (BU), the contact region, and the second contact element (ST);
    - it includes means for generating an induction voltage ($U_{ind}$) for a method according to claim 1.

10. Plug device according to the preamble of claim 9, **characterized in that** it includes at least two sensors (F, F1, F2) which contact a complementary second contact element (ST) of the second plug device (SV2) each with its own and separate contact region when plugged together and that it comprises means for carrying out a method according to claim 2.

11. Plug device according to claim 9 or 10, **characterized in that** it includes a magnetic core (MK) which surrounds the first contact element (BU) and/or a sensor (F) and/or the contact region.

12. Plug device according to at least one of the claims 9, 10 or 11, **characterized in that** the plug device includes an evaluation circuitry (AS) for evaluating the properties of a current path according to a method according to one of claims 1 to 8.

**Revendications**

1. Procédé destiné à déterminer les propriétés de transition (RÜ) électriques dans la région de contact entre un premier élément de contact (BU) d'un premier dispositif à enfichage (SV1) et un second élément de contact (ST) qui lui est complémentaire d'un second dispositif à enfichage (SV2), dans lequel le premier élément de contact est une prise femelle (BU) et le second élément de contact est une prise mâle (ST) ou inversement, et dans lequel les propriétés d'un trajet de courant sont évaluées, lequel contient le premier élément de contact (BU), la région de contact et uniquement le second élément de contact (ST) du second dispositif à enfichage (SV2); **caractérisé en ce que**

    - le trajet de courant est fermé et contient uniquement le premier élément de contact (BU), la région de contact et le second élément de contact (ST) ;
    - dans le trajet de courant est produite une tension d'induction ($U_{ind}$) à l'aide de laquelle des mesurages sont effectués dans le trajet de courant, lesquels permettent des déductions sur les propriétés de transition d'intérêt.

2. Procédé selon le préambule de la revendication 1, en particulier procédé selon la revendication 1, **caractérisé en ce que**

    - le trajet de courant contient au moins deux capteurs (F, F1, F2), lesquels sont agencés dans le premier dispositif à enfichage (SV1) et touchent, à l'état d'enfichage ensemble, le second élément de contact (ST) avec respectivement une région de contact propre et séparée ;

    dans lequel

    a) trois ou plusieurs trajets de courant sont évalués, lesquels contiennent des combinaisons différentes des au moins trois régions de courant qui sont formées entre (i) le second élément de contact et (ii) le premier élément de contact et/ou les différents capteurs, et/ou
    b) un courant est injecté via le premier élément de contact (BU), le second élément de contact (ST) et l'un des capteurs (F2), dans lequel est mesurée la chute de tension entre le premier élément de contact (BU) et l'autre capteur (F1).

3. Procédé selon le préambule de la revendication 1, en particulier procédé selon au moins l'une des revendications précédentes,
**caractérisé en ce que** l'évaluation est synchronisée avec le tracé d'un courant alternatif de fonctionnement ($I_B$) sur la région de contact, **en ce que** des mesurages sont réalisés de préférence dans la plage des passages par zéro du courant alternatif de fonctionnement.

4. Procédé selon le préambule de la revendication 1, en particulier procédé selon au moins l'une des revendications précédentes,
dans lequel le trajet de courant contient au moins un capteur (F, F1, F2), lequel est agencé dans le premier dispositif à enfichage (SV1) et touche, à l'état d'enfichage ensemble, le second élément de contact (ST), **caractérisé en ce que** le trajet de courant entre le capteur (F, F1, F2) et le second élément de contact (ST) est conducteur uniquement de façon capacitive et qu'une capacité de plus de 10 pF environ y est formée qui permet un flux de courant alternatif dans le trajet de courant.

5. Procédé selon au moins l'une des revendications précédentes, **caractérisé en ce que** la chute de tension ($U_B$) est mesurée sur le trajet de courant, laquelle apparaît sur la région de contact lors d'un flux d'un courant de fonctionnement ($I_B$).

6. Procédé selon au moins l'une des revendications précédentes, **caractérisé en ce que** des propriétés de transition définies sont produites entre le capteur (F, F1, F2) et le second élément de contact (ST), de préférence par l'application d'une tension de rupture ($U_D$).

7. Procédé selon au moins l'une des revendications précédentes, **caractérisé en ce que** le trajet de courant forme la bobine secondaire sur un noyau magnétique (MK) sur lequel est en outre disposée une bobine primaire (PSP).

8. Procédé selon au moins l'une des revendications précédentes, **caractérisé en ce que** le trajet de courant contient au moins deux doigts de contact (KF1, KF2, KF3, KF4), lesquels entrent tous deux en contact avec la même tige de contact (ST).

9. Dispositif à enfichage (SV1) avec au moins un premier élément de contact (BU), lequel, à l'état d'enfichage ensemble, entre en contact avec un second élément de contact (ST) complémentaire d'un second dispositif à enfichage (SV2) dans une région de contact,

dans lequel le premier élément de contact est une prise femelle (BU) et le second élément de contact est une prise mâle (ST) ou inversement, et dans lequel le dispositif à enfichage (SV1) présente un trajet de courant, lequel contient le premier élément de contact (BU), la région de contact et uniquement le second élément de contact (ST) complémentaire du second dispositif à enfichage (SV2),
**caractérisé en ce que**

- le trajet de courant est fermé et contient uniquement le premier élément de contact (BU), la région de contact et le second élément de contact (ST) ;
- il contient des moyens pour produire une tension d'induction ($U_{ind}$) pour un procédé selon la revendication 1.

10. Dispositif à enfichage selon le préambule de la revendication 9, **caractérisé en ce qu'**il contient au moins deux capteurs (F, F1, F2), lesquels touchent, à l'état d'enfichage ensemble, un second élément de contact (ST) complémentaire du second dispositif à enfichage (SV2) avec respectivement une région de contact propre et séparée, et qu'il contient des moyens pour exécuter un procédé selon la revendication 2.

11. Dispositif à enfichage selon la revendication 9 ou 10, **caractérisé en ce qu'**il contient un noyau magnétique (MK), lequel entoure le premier élément de contact (BU) et/ou un capteur (F) et/ou la région de contact.

12. Dispositif à enfichage selon au moins l'une des revendications 9, 10 ou 11,
**caractérisé en ce qu'**il contient un circuit d'évaluation (AS) pour évaluer les propriétés d'un trajet de courant selon un procédé selon au moins l'une des revendications 1 à 8.

SV1

KF

BU

KF2

SV2

ST

# Fig. 1

F

a

b

BU

ST

# Fig. 2

F

a

b

BU

ST

F'

ST'

# Fig. 3

a

b

F1

BU

ST

c

F2

Fig. 4

b

a

F

BU

ST

Fig. 5

a

b

$R_F$

$R_Ü$

Fig. 6

Fig. 7

Fig. 8

Fig. 9

MK

D17

KF1

KF2

1,6

KF4

KF3

y

z    x

AS

PSP

# Fig. 10

PSP

BU

$U_{ind}$

KF2, KF4

ST

MK

KF1, KF3

y    x

z

AS

# Fig. 11

Fig. 12

Fig. 13

MK

BU  U_{ind}  ST

## Fig. 14

MK

## Fig. 15

ST

KF2    HF

MK

BU    ST

## Fig. 16

B    A

Fig. 17

Fig. 18

Fig. 19

Fig. 20

Fig. 21

**IN DER BESCHREIBUNG AUFGEFÜHRTE DOKUMENTE**

**In der Beschreibung aufgeführte Patentdokumente**

- JP 2007285833 A
- CN 206848406
- CN 202008524
- EP 2944503 A2
- WO 2016184673 A1